# EUROPEAN PATENT APPLICATION

(11) **EP 4 243 060 A1**
(43) Date of publication of application: **13.09.2023**
(21) Application number: 23160612.0
(22) Date of filing: 07.03.2023
(51) Int. Cl.: H01L 21/67, H01L 21/683, H01L 21/687

(54) **APPARATUS AND METHOD FOR PROVIDING WAFERS FOR AUTOMATIC ASSEMBLY MACHINE, AND ASSEMBLY SYSTEM**

(30) Priority: 11.03.2022 CN 202210239266
(71) Applicant: ASMPT GmbH & Co. KG, 81379 Munich (DE)
(72) Inventor: KIENER, Rudolf, 82538 Geretsried (DE); BENZ, Wolfgang, 90762 Fürth (DE); LIEBEKE, Thomas, 85521 Ottobrunn (DE); Jian Min, CHEN, Chengdu City (CN); DEMMEL, Sylvester, 83043 Bad Aibling (DE)
(74) Representative: Emerson, Peter James

(57) **Abstract**

The present invention describes an apparatus for providing wafers with separated chips for an automatic assembly machine. The apparatus comprises: (a) a receiving device for receiving the provided wafers to remove the chips by an assembly head of the automatic assembly machine; (b) a storage device having a plurality of storage positions for accommodating each wafer; and (c) a wafer conveying device for conveying the wafers between the storage device and the receiving device. The wafer conveying device has at least a first conveying station and a second conveying station, and is configured to first transfer a first wafer from the receiving device to the first conveying station and then transfer a second wafer from the second conveying station to the receiving device. The present invention further describes a method for providing wafers and a system for assembling chips for a component carrier, and the system comprises such apparatus for providing the wafers.

## Description

### Technical Field

The present invention generally relates to the technical field of assembling electronic components for a component carrier by an automatic assembly machine. In particular, the present invention relates to supply of electronic components directly from wafers to an automatic assembly machine. Specifically, the present invention relates to an apparatus and method for providing wafers with separated chips for an automatic assembly machine. The present invention further relates to a system for assembling chips for a component carrier, and the system has such apparatus for providing wafers.

### Background

Almost every type of electronic apparatus involves the manufacture of electronic component groups, including the assembly of electronic components for a component carrier (e.g., a printed circuit board). The component carrier not only represents a mechanical bearing structure for the components, but also includes a large number of electrical contacts (i.e., so-called pads) and conductor lines connected to the pads, and the assembled components are electrically "wired" to these conductor lines in an appropriate manner.

The component carrier is usually assembled in an automatic assembly machine, and the automatic assembly machine is provided with at least one component supply device, an assembly head and a conveying system for the component carrier. During the assembly operation, the assembly head picks up the components provided by the component supply device at a pick-up position and places the components at a specified position on the component carrier, the component carrier is brought into an assembly area of the automatic assembly machine by the conveying system before the assembly, and is taken out from the assembly area after being at least partially assembled, so as to supply the at least partially assembled component carrier for a further processing procedure. Such further processing procedure may be, for example, further assembly in the downstream automatic assembly machine or welding of the assembled components to corresponding electrical connection contacts. This procedure is usually performed in a so-called reflow oven.

Currently, the components are usually conveyed to a provision position by a component tape. A large number of components are stored in each notch in the component tape, and these notches are also referred to as component tape pockets. The component tape is gradually conveyed in a direction toward the provision position by a rotatable pin wheel jointed into a lateral punched hole of the component tape. At this provision position, the assembly head takes out relevant components from the component tape pockets. A component tape section with the components emptied in this manner is cut off from the remaining component tape by a cutting device and sent for waste treatment. However, packaging the components in the component tape is relatively complicated. In addition, the components packaged in the component tape occupy a lot of space, and the waste treatment is not only bulky and costly, but also causes a burden to the environment.

Electronic components constructed as semiconductor chips may also be directly supplied by wafers to prevent the above-mentioned defects of the component tape. In this regard, the wafers are an arrangement further comprising a film and a frame in addition to an actual wafer (i.e., a disk sheet made of a semiconductor material), wherein the frame tensions the film, and the actual wafer adheres to the film. Such (adhesive) film is also commonly referred to as a "wafer film". The wafers adhered to foil may also have dispersed (by a sawing process), so that a plurality of individual semiconductor chips are adhered to the foil. Such arrangement composed of the frame, the film and the separated semiconductor chips is often referred to as a "wafer film frame". In addition, in this regard, the wafer or the "wafer film frame" may also be a so-called "reconstituted wafer", wherein defective chips or chips out of a certain tolerance have been sorted out before the assembly onto the film. By tensioning the adhesive film, the separated semiconductor chips may be slightly "pulled apart" and picked up by a component holding device, for example, so-called suction forceps of the assembly head. The pick-up of the semiconductor chips may be supported by an ejector, which pierces the adhesive film by at least one needle or at least arches the adhesive film, so that an adhesive force of relevant semiconductor chips on the adhesive film is reduced.

However, since a wafer usually contains only one type of electronic components or semiconductor chips, while the electronic components are usually many different components. Therefore, for example, after about 25 to 1000 semiconductor components are placed on a larger component carrier, a wafer with a first type of components needs to be replaced into another type of wafer with a second type of components in the automatic assembly machine. During such replacement, the assembly operation is interrupted, so such replacement should be completed as soon as possible so as not to degrade the assembly performance.

An objective of the present invention is to be able to supply different semiconductor components directly from wafers as uninterrupted as possible.

### Summary

The solution of the present invention to achieve the above objective is the subjects of the independent claims. For advantageous implementation solutions of the present invention, refer to the dependent claims.

According to a first aspect of the present invention, an apparatus for providing wafers with separated chips for an automatic assembly machine is described. The apparatus comprises: (a) a receiving device for receiving the provided wafers to remove the chips by an assembly head of the automatic assembly machine; (b) a storage device having a plurality of storage positions for accommodating each wafer; and (c) a wafer conveying device for conveying the wafers between the storage device and the receiving device. The wafer conveying device has at least a first conveying station and a second conveying station, and is configured to first transfer a first wafer from the receiving device to the first conveying station and then transfer a second wafer from the second conveying station to the receiving device.

The wafer providing apparatus is based on the following understanding: after the first wafer is removed, the second wafer is "prepared" in the wafer conveying device, so that the second wafer can be introduced into the receiving device particularly quickly or without serious time lag. In this way, the time for chip removal and the wafer replacement time during which the entire assembly operation of the automatic assembly machine must be interrupted can be kept extremely short. A direct result is that the assembly performance of the automatic assembly machine can be improved. In this regard, the term "assembly performance" refers to the number of chips that the assembly head can pick up and place at a predetermined assembly position on a component carrier within a specific period of time (e.g., 1 hour).

According to an assembly process used, the chips may be sequentially removed, that is, the chips are removed successively, or the chips may be removed in parallel. During parallel removal, at least two chips are removed simultaneously, which can be completed in particular by using a so-called multi-assembly head, and the multi-assembly head has two or more chip holding devices, which can hold each chip (in particular by negative pressure).

In the above content, the first wafer is a wafer that provides components for an assembly procedure before (just before) wafer replacement.
(A) In a first type of wafer replacement, the chips are at least almost completely emptied from the first wafer. The second wafer usually contains the same type of chips. When a new type of chips needs to be assembled by the automatic assembly machine while the wafer is replaced, the second wafer may only contain different types of chips.
(B) In a second type of wafer replacement, the first wafer still contains some chips that are not completely emptied. Generally, the wafer is replaced because the further assembly procedure requires different types of chips. Because a new wafer usually contains many chips, the second type of wafer replacement occurs in most cases in practice. Therefore, the first wafer that is not "used up" may be stored in the storage device, and may be used again at a later time if necessary, that is, be introduced into the receiving device.

As mentioned above, the wafer herein especially refers to a so-called wafer film frame, which has, on its adhesive film, (i) semiconductor chips dispersed by a sawing process or (ii) mounted semiconductor chips, depending on an application situation. The wafer film frame with (selected) assembled semiconductor chips is often referred to as an artificial wafer. As mentioned above, the wafer or the wafer film frame further comprises a frame structure for tensioning an elastic film. The frame structure of the wafer film frame may be especially a flat metal frame that is free from unnecessary high expansion, which can also ensure that the wafer film frame can be easily and safely manipulated. This manipulation may be performed, for example, by a mechanical arm or a significantly simpler manipulation device, the manipulation device holds the frame structure by a clamp and makes the wafer or the wafer film frame translate, for example, only along a predetermined direction by appropriate motion.

The technology described herein mainly involves the manipulation of the wafer film frame, rather than the treatment of the semiconductor wafer (disk sheet). Therefore, only the more concise term "wafer" is generally used herein to refer to the "wafer film frame".

The chip herein refers to any assemblable electronic component that can be removed from a wafer. The chip, especially an unpackaged or "naked" electronic component, is substantially composed of a semiconductor material and is processed or manufactured together with other chips on the same semiconductor wafer. In addition to the semiconductor material of an original wafer, the chips may further have metal connection contacts, which are formed for all chips of the wafer at the same time in an appropriate post-processing environment. In the case of spherical connection contacts, the chips may be, in particular, an unpackaged so-called flip chip ball grid array (FCBGA). In addition, the chips may further have electroplated raised connection contacts, which further contain an appropriate electrically-conductive and thermally-conductive jointing material (solder). Generally, such components are referred to as chip scale packages (CSP). After unpackaged chips are assembled on the component carrier, such as a printed circuit board (PCB), the assembled chips may be protected against harmful environmental influences by an appropriate coating and/or a potting compound if necessary. In this broader sense, the potting compound may also be an underfill material introduced below assembled components.

The wafer conveying device may also be regarded as a (mobile) buffer device, so that the above second wafer can be kept ready next to the receiving device. After the at least partially consumed first wafer is removed, more precisely, after the first wafer is conveyed to the first conveying station, the new second wafer can be conveyed from the second conveying station to the receiving device very quickly. A corresponding wafer may be fixed in or over the receiving device in a known manner, for example, by mechanically clamping the frame structure.

Compared with the use of a conventional mechanical arm to convey single wafers between the storage device and the receiving device, by using the wafer conveying device, a particularly large storage device may also be used, and an averagely longer conveying route associated therewith does not lead to the undesired prolonging of the wafer replacement time. Of course, in the apparatus according to the present invention, a large storage device with high capacity with regard to the number of wafers that can be stored at the same time will naturally also result in an averagely longer conveying route, because the wafers must be picked up from many different storage positions (usually vertically spaced). However, due to the above buffering function, the wafer conveying device can already pick up the second wafer in advance while the chips of the first wafer are still being assembled. A conveying distance passed during this assembly period naturally does not affect the wafer replacement time, which is related to the interruption of the assembly operation.

According to embodiments of the present invention, the wafer conveying device is configured to transfer the wafers between each storage position and the first conveying station. Alternatively or in combination, the wafers may be transferred between each storage position and the second conveying station. In short, each of the at least two conveying stations can reach each storage position for wafer transfer. In this way, there is no restriction on selection of a specific (type of) wafer that is conveyed on the first conveying station and a specific (type of) wafer that is conveyed on the second conveying station. With regard to providing the specific type of wafer in the receiving device, the wafer providing apparatus can be applied with the highest flexibility.

According to another embodiment of the present invention, the first conveying station and the second conveying station are configured (i) such that a first orientation of the first wafer at the first conveying station is parallel to a second orientation of the second wafer at the second conveying station, and (ii) such that the two conveying stations are staggered (only) perpendicular to main planes of the two wafers.

In short, in this implementation solution, the wafer conveying device is configured such that the two wafers are arranged up and down if located at corresponding conveying stations at the same time. This corresponds to a "spaced" arrangement in a stacked form, which advantageously allows the wafer conveying device to realize a compact configuration.

In the present invention, the main planes refer to planes along which the relevant wafers have a maximum extension range. The main planes are especially determined by elastic adhesive films which represent constituent parts of the two wafers.

The advantage of a stacked arrangement is that the first conveying station or the second conveying station can be selectively aligned with the receiving device by simply shifting the wafer conveying device. The actual transfer between the wafers and the relevant storage positions can be realized by simple pure translational motion in the main planes of the corresponding wafers.

According to another embodiment of the present invention, the apparatus further comprises a shifting device, which is coupled to the wafer conveying device and configured to translate the wafer conveying device along a first direction, so as to be reachable to each storage position of the storage device to transfer the wafers between the storage device and the wafer conveying device. This advantageously allows the wafer conveying device to easily access various different storage positions. In particular, the use of a simple track system is enough to allow the wafer conveying device to be reachable to various different storage positions.

According to another embodiment of the present invention, the first direction is perpendicular to a second direction along which the wafers are transferred between the wafer conveying device and the receiving device. On the one hand, this advantageously allows a large number of wafers to be accommodated in the storage device, while one side next to the automatic assembly machine does not need a particularly large vacancy or installation space. On the other hand, a distance that has to be passed for transfer between the wafer conveying device and the receiving device can be kept relatively short. In this way, a very short wafer replacement time can be realized.

According to another embodiment of the present invention, the first direction is a vertical z-direction, and the second direction is a horizontal x-direction. This has the advantages that the corresponding wafer is supplied to the receiving device along the second direction, which is perpendicular to a typical (vertical) chip removal direction, the assembly head of the automatic assembly machine removes the chips along the chip removal direction, then the assembly head conveys the corresponding chips to an assembly area of the automatic assembly machine, and there is the component carrier waiting for assembly in the assembly area. In this case, the chip removal direction is determined by a translational motion direction of the components or chip holding devices of the corresponding assembly head in a known manner. The wafer transfer along the horizontal x-direction advantageously realizes a certain degree of decoupling between the introduction into the receiving device along the x-direction (of course, also the removal of the wafers from the receiving device) and the removal of the chips from the introduced wafers along the z-direction. This can ensure high process reliability, especially during the supply of the chips to the automatic assembly machine.

According to another embodiment of the present invention, the apparatus further comprises a conveying device, which is configured to (i) transfer the wafers between the wafer conveying device and the storage device, and/or (ii) transfer the wafers between the wafer conveying device and the receiving device.

With regard to the transfer between the wafer conveying device and the storage device, the transfer device is preferably associated with the wafer conveying device. This shows that when the wafer conveying device moves (translates or linearly moves), the transfer device will automatically move therewith. The transfer device can be advantageously used for wafer transfer between the wafer conveying device and each of a plurality of storage positions.

With regard to the transfer between the wafer conveying device and the receiving device, the transfer device may be associated with the wafer conveying device or the receiving device. Such wafer transfer does not involve a plurality of different possible wafer positions. With regard to the wafer conveying device, only two conveying stations are involved as possible wafer positions. In the receiving device, there is preferably only one single receiving position as a wafer position.

The transfer device may also be configured such that it is available for both (i) the transfer between the wafer conveying device and the storage device and (ii) the transfer between the wafer conveying device and the receiving device. This can be realized by the transfer device with a corresponding manipulation area, and the manipulation area extends on two opposite sides of the wafer conveying device.

In order to manipulate each wafer, the transfer device may have an appropriate manipulation component, for example, at least one clamp, a sliding rod, etc. Those skilled in the art that are familiar with wafer manipulation may conceive of a mechanism suitable for every possible application case of the wafer providing apparatus, so possible structural details are not described herein again.

According to another embodiment of the present invention, the transfer device comprises (a) a first transfer mechanism associated with the first conveying station and (b) a second transfer mechanism associated with the second conveying station.

Providing one transfer mechanism in each embodiment can further help to particularly quickly realize wafer replacement at or next to the position of the receiving device. This further shortening of the wafer replacement time may be especially based on: after the first wafer is removed, it is not necessary to "switch" to the second wafer, for example, only one single transfer mechanism shared by two conveying stations is used.

In the case of the above-mentioned implementation solution of the wafer conveying device, the two conveying stations are staggered along the vertical z-direction, that is, the two wafers are held parallel up and down in the wafer conveying device in a stacked form, and the two transfer mechanisms may also be arranged in corresponding planes that are mutually vertically spaced. In this case, the two transfer mechanisms and the entire wafer conveying device can all realize the compact configuration, especially in a vertical direction. The two transfer mechanisms may preferably have only movable components, such as clamps or sliding rods, which are arranged or actuated between the wafer conveying device and the receiving device in a manner of moving along the horizontal second direction.

According to another embodiment of the present invention, the wafer conveying device comprises at least one third conveying station so that a third wafer can be conveyed between the storage device and the receiving device.

The third conveying station improves a "conveying capacity" of the wafer conveying device, and it may be particularly advantageous that two wafer replacements at short intervals are required for a specific assembly task, for example, a first wafer replacement from the first wafer to the second wafer and a second wafer replacement from the second wafer to the third wafer before long. In this case, when the second wafer is used, that is, when the chips of the second wafer are assembled, it is neither necessary to "store" the first wafer in the storage device according to a corresponding travel path of the wafer conveying device, nor necessary to "release" the third wafer from the storage device according to a corresponding travel path of the wafer conveying device and provide the third wafer to a position adjacent to (next to) the receiving device. In this regard, it is very obvious that in such an application case where a period of time required for "storing" and "releasing" is longer than that for assembling the chips from the second wafer, providing the second wafer and the third wafer in advance at the same time may have a significant time advantage when the chips are assembled from three different wafers (having different types of chips).

The wafer conveying device may be configured to also transfer the wafers between each storage position and the third conveying station. In addition, according to the first conveying station and the second conveying station, the third conveying station may also be configured such that the third wafer accommodated therein is staggered in parallel relative to the other two wafers along the vertical z-direction.

According to another embodiment of the present invention, the storage device is a static storage device, which can be coupled to a machine frame of the automatic assembly machine in a position-fixed manner.

Such static storage device can be particularly well integrated into the automatic assembly machine or stably attached to the automatic assembly machine. In this way, an assembly system composed of the automatic assembly machine and the wafer providing apparatus can be constructed, and due to fixed space allocation, the assembly system allows the automatic assembly machine to reliably provide or supply the chips for the assembly procedure.

According to another embodiment of the present invention, the wafer providing apparatus further comprises an additional storage device having a plurality of additional storage positions for receiving each wafer. In addition, the wafer conveying device is configured to convey the wafers between the additional storage device and the receiving device.

By using the additional storage device, the storage capacity in terms of the number of wafers can be simply increased. In addition, when two storage devices are equipped with the wafers with different types of chips, the types of chips that can be efficiently and quickly supplied to the assembly procedure can be increased significantly. The wafer providing apparatus can be variously and flexibly applied to many different assembly tasks.

According to another embodiment of the present invention, the additional storage device is a mobile storage device, which is directly or indirectly attached to the machine frame of the apparatus or the storage device in a replaceable manner.

By using the mobile storage device, the supply of the wafers can be ensured particularly efficiently. Specifically, with delivery and subsequent removable attachment of the mobile storage device equipped with appropriate wafers (for example, may be realized in a box type and may be referred to as a "wafer film frame box"), a plurality of wafers can be dominated for manipulation at the same time in the wafer providing apparatus. This is also applicable to efficiently transporting away at least partially consumed or emptied wafers. The arrival and/or transporting away may be performed manually by an operator or alternatively, may be performed automatically, for example, by an autonomous vehicle. In addition, the mobile storage device may be manually or automatically (in advance) filled with the appropriate wafers at an external loading station. This advantageously enables further automation of the assembly of the chips for the component carrier.

According to another embodiment of the present invention, the wafer conveying device is further configured to convey the wafers between the storage positions of the storage device and the additional storage positions of the additional storage device. This can advantageously realize targeted or desired reclassification of the wafers between the storage device and the additional storage device. In particular, the wafers required for the assembly before long can be transferred from the additional storage device to the storage device. In addition, the wafers that are mostly consumed or may be expected not to be used for the assembly in the future may be conveyed or transferred from the storage device to the additional storage device. In this way, the wafers can be distributed between the two storage devices, so that wafers that are less relevant or no longer relevant to the assembly in the future can be stored in the additional mobile storage device. Then the additional mobile storage device may be transported away and replaced into another mobile storage device or another additional storage device loaded with wafers having higher correlation with subsequent assembly tasks. In this way, particularly "important" wafers for subsequent assembly tasks can be always prepared in the wafer providing apparatus.

According to another aspect of the present invention, an assembly system for assembling chips for a component carrier is described. The assembly system comprises: (a) an automatic assembly machine with an assembly head for picking up the chips and placing the chips at a predetermined assembly position on the component carrier; and (b) an apparatus for providing the chips of wafers described above, wherein the provided wafers are received in a receiving device.

The assembly system is based on the following understanding: the assembly performance of the automatic assembly machine can be particularly effectively improved by shortening the wafer replacement time. As mentioned above, the wafer replacement time can be shortened, because the second wafer required in the future has been held in or at the position of one of the two conveying stations in advance, while the other conveying station remains idle, so that the first wafer that is currently still in use can be quickly received when the wafer is replaced. After the first wafer has been removed, the second wafer can be introduced into the receiving device immediately without wafer conveying between the wafer conveying device and the storage device (or the additional storage device).

According to a still another aspect of the present invention, a method for providing wafers with separated chips for an automatic assembly machine is described, wherein the wafer providing apparatus described above is used. The method comprises: (a) transferring a first wafer from a receiving device to a first conveying station; and (b) transferring a second wafer from a second conveying station to the receiving device.

The method is based on the following understanding: after the first wafer has been removed, the second wafer is "prepared" in a wafer conveying device, so that the second wafer can be introduced into the receiving device particularly quickly or without long time lag. As detailed above, this can effectively shorten the wafer replacement time. This can shorten a non-production time window during which the assembly has to be stopped or interrupted due to the lack of provided chips, thereby enabling the effective assembly performance of the automatic assembly machine to be improved.

According to an embodiment of the present invention, the method further comprises: (a) conveying the first wafer into a storage device by the wafer conveying device; and (b) conveying a third wafer from a storage device to a provision position beside (near) the receiving device by the wafer conveying device. In short, by providing the third wafer in advance, another wafer replacement is prepared, which can also be performed in a quiet short period of time.

For the conveying of the third wafer, it is not mandatory to use the first conveying station. After the first wafer is conveyed to the storage device, the two conveying stations become idle, and thus the two conveying stations can also be used to receive the third wafer.

According to another embodiment of the present invention, the method further comprises: (a) transferring the second wafer from the receiving device to a conveying station unoccupied by the third wafer; and (b) transferring the third wafer from the wafer conveying device to the receiving device.

Another wafer replacement described herein may also be completed in a very short period of time, because the third wafer is prepared in advance at a position as close as possible to the receiving device. In principle, this is also applicable to any number of subsequent wafer replacements, which are initiated by corresponding matched wafers prepared in advance.

According to another embodiment of the present invention, the method further comprises: changing a mechanical tension of an adhesive film tensioned by a frame structure of a corresponding wafer and attached with separated chips. In this case, changing the mechanical tension is performed subsequently or in a time window when the corresponding wafer is located in the wafer conveying device.

This clearly shows that, unlike a known apparatus, the tension or a tension state of the adhesive film is changed not inside the receiving device but outside the receiving device. Such change usually takes a certain time. For an application where the removal of the chips by the assembly head requires the chips to be "pulled apart" in advance by tensioning the adhesive film, it may also further shorten an effective period of time required for effective wafer replacement or an effective period of time during which the chips cannot be removed.

Accordingly, after the chips are removed from the unfolded adhesive film, the corresponding wafer may also be transferred from the receiving device to the wafer conveying device in an unfolded state of the adhesive film, and the mechanical tension is reduced again only at this time or this position. Because the procedure of relaxation or contraction of the adhesive film also takes a certain time, which is usually longer than the time required for tensioning the adhesive film, precious time can also be saved by "outsourcing" this relaxation/contraction procedure from the receiving device to the wafer conveying device when the partially consumed wafer is removed. This will also make a valuable contribution to shortening the wafer replacement time.

In this regard, it should be noted that the previously tensioned wafer (or the wafer film frame) may also be introduced into the wafer conveying device of the wafer providing apparatus. Therefore, there is no need (or it is no longer required) to tension the wafer film (or the wafer film frame) in a "working area" of the wafer conveying device. It should also be noted that the tensioned wafer (or the wafer film frame) may also be stored outside the receiving device and the wafer conveying device in a tensioned state for subsequent use, that is, for removing the chips. Such tensioned wafer may also be stored in the storage device and/or the additional storage device of the wafer providing apparatus.

Of course, since the tensioned state of the adhesive film is changed externally, there is a need for both (A) the presence of an appropriately constructed mechanism/component in or over the wafer conveying device to cause such a tensioning state change, and (B) providing an appropriately constructed mechanism/component to keep a varied tensioned state during the conveying and/or the conveying from the receiving device and inside the receiving device. Those skilled in the art may conceive of appropriately constructed mechanisms/components for the two tasks (A) and (B).

It should be noted that implementation solutions of the present invention have been described above with reference to different subjects of the present invention. In particular, some implementation solutions of the present invention are described by product claims, while some other implementation solutions of the present invention are described by method claims. However, after reading the present application, those skilled in the art can clearly understand that in addition to a combination of features belonging to one type of subject of invention, there may also be any combination of features belonging to different types of subjects of invention, unless otherwise explicitly stated.

More advantages and features of the present invention will be apparent from the following examples of preferred implementation solutions of the present invention.

### Brief Description of the Drawings

FIG. 1 shows a schematic side view of an assembly system with an automatic assembly machine and a wafer providing apparatus according to embodiments of the present invention.
FIG. 2 shows a transfer device for two wafers.
FIG. 3a to FIG. 3h show a procedure of rapid wafer replacement from a first wafer to a second wafer and subsequent provision of a third wafer in advance.
FIG. 4 shows a rearrangement of wafers between a static wafer storage device and a mobile wafer storage device.

### Detailed Description

It should be noted that in the following specific implementations, features or components of different implementation solutions and corresponding features or components of other implementation solutions are marked with the same reference numerals when they are identical, or at least functionally identical. In order to avoid repetition, the features or components that have been described based on the foregoing implementation solutions will not be described again in detail below.

It should also be noted that the implementation solutions described below only show a limited selection of possible variant solutions of the present invention. In particular, the features of various implementation solutions may be combined with each other by adopting an appropriate manner, so that those skilled in the art can clearly understand that there are many different implementation solutions of variant solutions explicitly expressed herein.

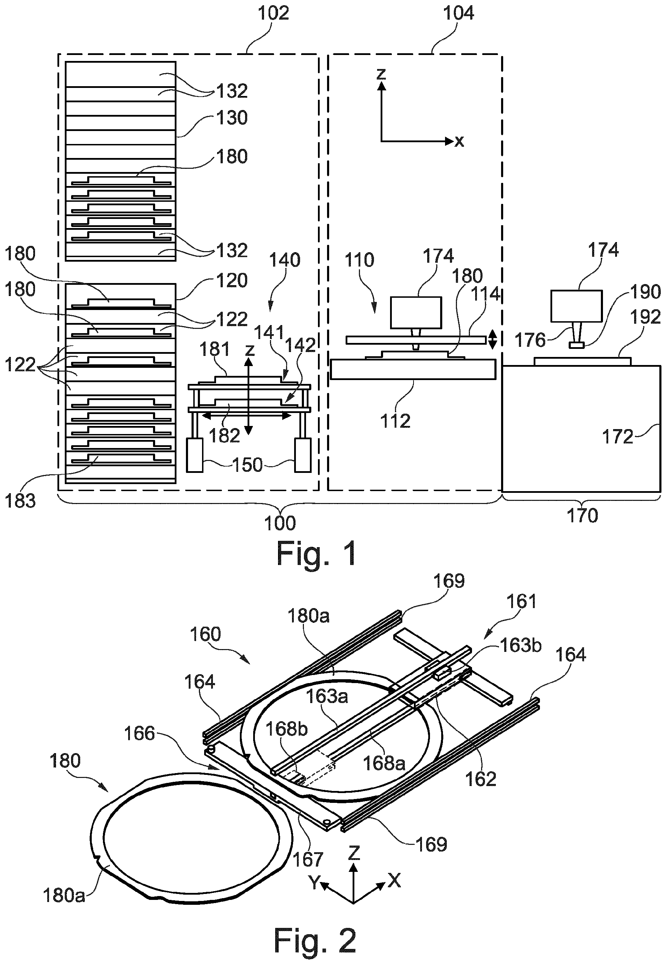

FIG. 1 shows a system for assembling chips 190 for a component carrier 192. The system herein is also referred to as assembly system for short, and has a (conventional) automatic assembly machine 170 and an apparatus 100 for providing wafers 180 with separated chips to the automatic assembly machine 170. The apparatus herein is also referred to as a wafer providing apparatus 100 for short.

In a known manner, the automatic assembly machine 170 particularly has a machine frame 172 and an assembly head 174. The assembly head can move relative to the machine frame 172 by a gantry system (not shown) along at least two spatial directions, namely, an x-direction and a y-direction oriented perpendicular to accompanying drawing paper. The assembly head 174 may also preferably move along a vertical z-direction.

The assembly head 174 has at least one chip holding device 176, and the chip holding device 176 can move along the vertical z-direction relative to the assembly head 174 by a z-driver (not shown) in a known manner. According to the embodiment shown in this figure, the chip holding device 176 is so-called suction forceps, which can hold the chips 190 by negative pressure. Once the suction forceps 176 touch the corresponding chips 190 from above and then pick up the chips, the negative pressure is also activated in a known manner. When the chips 190 are conveyed to the component carrier 192 to be assembled, the negative pressure remains "activated". Such conveying comprises: (i) lifting the chips 190 by the suction forceps 176 and/or the assembly head 174; (ii) making the assembly head 174 move horizontally into an area above the component carrier 192; and (iii) lowering the chips 190 by the suction forceps 176 and/or the assembly head 174. When the chips 190 are conveyed from the suction forceps 176 to the component carrier 192, the negative pressure is "deactivated". If necessary, chip conveying may also be supported by transient air injection in a known manner.

The wafer providing apparatus 100 has a wafer receiving device 110 in a wafer provision area 104, and the wafer provision area 104 is next to the automatic assembly machine 170 or may be regarded as a part of the automatic assembly machine 170. According to the embodiment shown in this figure, the wafer receiving device 110 has a bearing table 112 and a clamping ring 114 that can move along the vertical z-direction. As shown in FIG. 1, when the clamping ring 114 is located at an upper position, the wafers 180 can be placed on the bearing table 112 or removed from the bearing table 112. When the clamping ring 114 is located at a lower position, the wafers 180 are fixed on the bearing table 112. Removal of the chips by the single assembly head 174 according to the embodiment shown in this figure can be completed by passing through an opening (not shown in FIG. 1) in the clamping ring 114. As shown in FIG. 1, the assembly head 174 is shown in the wafer provision area 104 and above the component carrier 192 to be assembled.

The wafer providing apparatus 100 comprises, in a wafer replacement area 102, a storage device 120 having a plurality of storage positions 122, and the wafers 180 may be stored in each of the storage positions 122. According to the embodiment shown in this figure, an additional storage device 130 having a plurality of additional storage positions 132 is arranged above the storage device 120, and the wafers 180 may also be stored in each of the additional storage positions 132. According to the embodiment shown in this figure, the storage device 120 is a static storage device, which is connected to a machine frame 172 of the automatic assembly machine 170 in a manner not shown. In contrast, the additional storage device 130 is a mobile storage device, which may be replaced with another additional storage device (not shown) filled (filled with other wafers), as described in detail below. In this regard, the other wafers refer to wafers containing different types of chips.

The wafer providing apparatus 100 further has a wafer conveying device 140 in the wafer replacement area 102. Its purpose is to convey the wafers 180 between (i) the storage device 120 or the additional storage device 130 and (ii) the wafer receiving device 110. In order to pick up (or store) respective desired wafers 180 from the storage device 120 or the storage device 130, the wafer conveying device 140 can move along the vertical z-direction by a shifting device 150. The wafer conveying device 140 further has a transfer device (not shown in FIG. 1) to transfer the wafers 180 between the corresponding storage position 122 or additional storage position 132 and the wafer conveying device 140 at an appropriate height of the wafer conveying device 140. A specific implementation solution of the transfer device will be described below with reference to FIG. 1.

As shown in FIG. 1, the wafer conveying device 140 in a "double-layer arrangement" has conveying stations for receiving each wafer 180. In FIG. 1, a first conveying station at an upper portion is marked with reference numeral 141, and a second conveying station at a lower portion is marked with reference numeral 142. In this way, two wafers can be accommodated at the same time, i.e., a first wafer 181 located on the first conveying station 141 and a second wafer 182 located on the second conveying station 142. When the wafer conveying device 140 is located at the appropriate height, the first wafer 181 or the second wafer 182 can be transferred to (or removed from) the wafer receiving device 110.

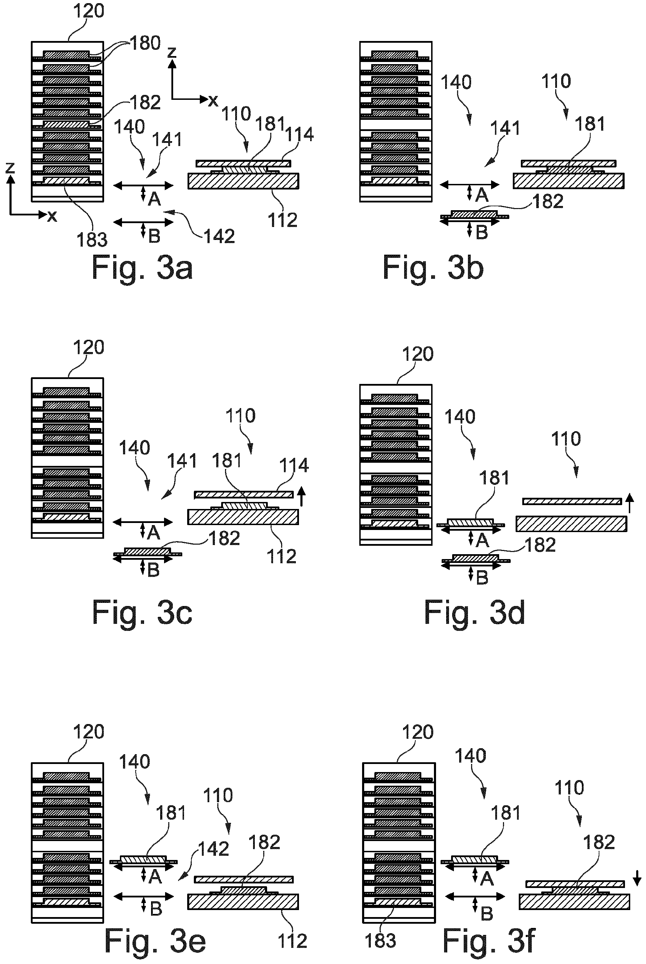

It should be noted that in the preferred wafer replacement procedure at the position of the wafer receiving device 110, the wafer conveying device 140 only temporarily accommodates the two wafers 181 and 182 at the same time. More details about this "logistics concept" will be described below with reference to FIG. 3a to FIG. 3g.

FIG. 2 shows a specific transfer device 160 for the two wafers. It can be noted by pure pre-consideration that this only represents one of a large number of possibly constructed implementation solutions, and those skilled in the art of wafer processing or general mechanical automation can usually conceive of other appropriately constructed solutions.

The wafer transfer device 160 has two transfer mechanisms, i.e., a first transfer mechanism 161 and a second transfer mechanism 166.

According to the embodiment shown in this figure, the first transfer mechanism 161 has a clamp 162, which may be used for clamping frame structures 180a of the wafers 180 and shifting along the x-direction. In this case, the frame structures 180a slide in a first guide rail 164 or a second guide rail 169. The clamp 162 can reciprocally move along the x-direction by a first linear driver comprising a static guide rod 163a and a mobile driving unit 163b. In addition, the clamp 162 has a mechanism (not shown) for actuating two clamping jaws configured on a front side of the clamp 162 and capable of clamping the frame structures 180a in a closed state. In particular, the wafers 180 in FIG. 1 can be moved and pulled from the lower left to the upper right in the figure. In this shifting procedure, the frame structures 180a remain in the corresponding guide rail, which is the first guide rail 164 here.

According to the embodiment shown in this figure, the second transfer mechanism 166 has a sliding rod 167. In FIG. 2, the wafers 180 located in the first guide rail 164 or the second guide rail can move from the "upper right" to the "lower left" along the x-direction with the sliding rod 167. The sliding rod 167 can move back and forth along the x-direction by a second linear driver comprising a static guide rod 168a and a mobile driving unit 168b. During the operation, the motion of the wafers 180 only requires forward motion from the "upper right" to the "lower left".

According to the embodiment shown in this figure, wafer replacement is performed in the following steps.
1. The transfer device 160 moves along the vertical z-direction, so that (according to the embodiment shown in this figure,) the first guide rail 164 is precisely located in a plane of the (first) wafer to be removed or replaced.
2. Then, the clamp 162 moves from a retracted position (the "upper right") of the clamp to an extended position (the "lower left") of the clamp.
3. The clamp 162 holds the frame structure 180a of the (first) wafer 180 to be replaced by clamping jaws of the clamp and pulls the frame structure from the extended position (the "lower left") of the clamp to the retracted position (the "upper right") of the clamp along the first guide rail 164 (as shown in FIG. 2).
4. In the next step, the two clamping jaws are opened.
5. Then, the entire wafer transfer device 160 (comprising the clamp 162 and the sliding rod 167) moves upward, so that the second guide rail 169 is located at the same height as a previous position of the first guide rail 164. In addition, the clamp 162 is turned up and/or further pushed up in a manner not shown, so that the clamp does not hinder further wafer replacement by the wafer transfer device 160.
6. At this time, the sliding rod 167 is positioned at a position (not shown) that will not hinder the downward turning and/or downward pushing operated by the clamp, so that the sliding rod can be clamped with the (second) wafer 180 located in the second guide rail 169.
7. Then, the sliding rod 167 moves from the retracted position (the "upper right") of the sliding rod to the extended position (the "lower left") of the sliding rod together with the second wafer 180 located in the second guide rail 169 (as shown in FIG. 2). At this time, the second wafer which is moved along the second guide rail 169 and then pops up is just located at the position where the first wafer was located at the beginning of the replacement procedure, and the first wafer is accommodated in the first guide rail 164 in the transfer device 160 at this time.

According to the embodiment shown in this figure, the transfer device 160 is attached to the wafer conveying device 140. Therefore, the transfer device 160 can also be moved along the vertical z-direction by the shifting device 150. Therefore, by appropriate height positioning, the transfer enabling the wafer 180 to leave the wafer conveying device 140 and enter the wafer conveying device 140 can be combined with the clamp 162 and the sliding rod 167 used here at any height. The height is determined by (i) a height of the corresponding storage position 122 or additional storage position 132 or (ii) a height of the wafer receiving device 110.

FIG. 3a to FIG. 3h show a procedure of rapid wafer replacement from the first wafer to the second wafer and subsequent provision of a third wafer in advance. In these figures, the wafer conveying device 140 is schematically shown by only two horizontal double arrows A and B, indicating the first conveying station 141 at the upper portion and the second conveying station 142 at the lower portion. Two vertical double arrows indicate that the two conveying stations 141 and 142 can be shifted up and down along a vertical direction by a shifting device (not shown).

In the procedure shown in the figure, wafers not involved are marked with reference numeral 180. The first wafer is marked with reference numeral 181. As shown in FIG. 3a, the first wafer is used at the beginning of the procedure described in this figure, and the first wafer is located in the wafer receiving device 110 and provides chips for the automatic assembly machine (not shown in this figure). The second wafer also involved in the procedure shown in this figure is marked with reference numeral 182, and the third wafer involved is marked with reference numeral 183. Compared with other wafers 180, the involved wafers 181, 182 and 183 are further shown with different shades.

When the chips are still removed from the first wafer 181 located in the wafer receiving device 110, the wafer conveying device 140 receives the second wafer 182 at the position of the second conveying station 142 at the lower portion. For this reason, the wafer conveying device 140 moves upward from an operating state shown in FIG. 3a, uses the transfer device (not shown) to remove the second wafer 182, and then moves downward. An end position shown in FIG. 3b is selected such that the first conveying station 141 at the upper portion is located at the same height as the first wafer 181 just used. This indicates that the subsequent conveying of the first wafer 181 from the wafer receiving device 110 onto or into the first conveying station 141 does not require further vertical movement of the wafer conveying device 140, but only requires horizontal movement of the wafer conveying device along an x-axis. This horizontal movement may be initiated by the transfer device alone. The wafer conveying device 140 is ready to receive the first wafer 181 in the first conveying station 141 of the wafer conveying device in an optimal manner.

As shown in FIG. 3c, after the chip removal of the first wafer 181 is completed, the clamping ring 114 moves upward, thereby releasing the fixation of the first wafer 181.

In the next step shown in FIG. 3d, the first wafer 181 is conveyed to the first conveying station, and reference numeral 141 of the first conveying station is not shown in the figure for the sake of clarity. Due to the previously set optimal height of the wafer conveying device 140, as described above, only the horizontal movement (along the x-direction) is required. Such movement is initiated by the transfer device (not shown).

Then, the wafer conveying device 140 is lifted so that the second conveying station 142 is at the same height as an upper side of the bearing table 112 of the wafer receiving device 110. In addition, the second wafer 182 is conveyed from the transfer device into the wafer receiving device 110. Refer to FIG. 3e for this state.

In the next step shown in FIG. 3f, the clamping ring 114 is lowered to further fix the second wafer 182 in the wafer receiving device 110. The chips can be removed from the second wafer 182 at this time.

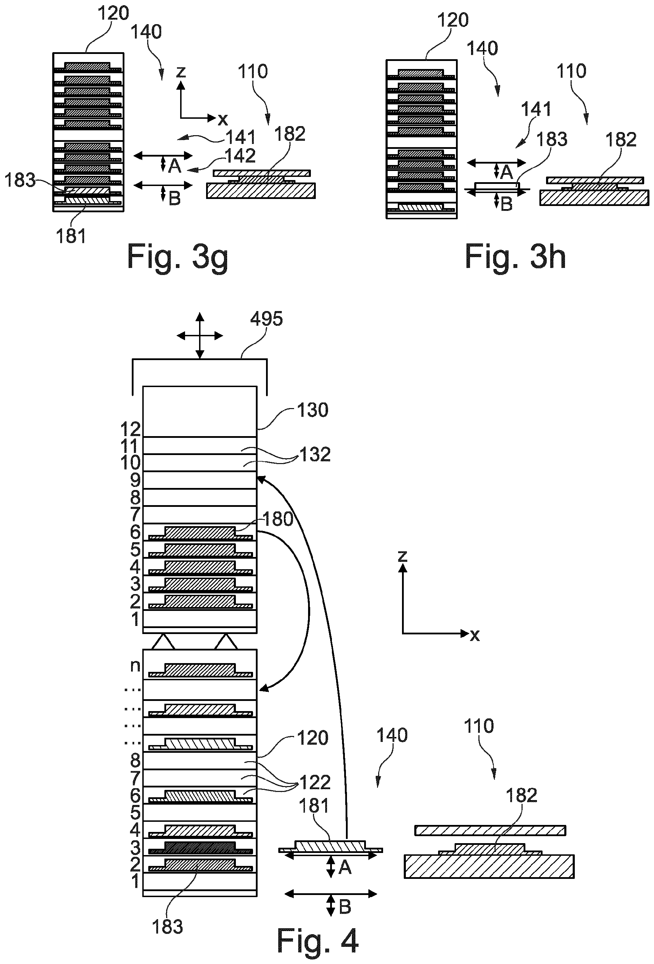

Then, as shown in FIG. 3g, the previously used first wafer 181 is "cleaned again" and stored in the storage device 120. According to the embodiment shown in this figure, such "cleaning" occurs in the lowest storage position 122. This requires the vertical movement of the wafer conveying device 140 and corresponding manipulation of the transfer device.

Then, as shown in FIG. 3h, the third wafer 183 is conveyed to the second conveying station 142 at the lower portion, and the wafer conveying device 140 vertically moves, so that the height of the second conveying station 142 is the same as that of the wafer receiving device 110. Thereby, the third wafer 183 is optimally prepared in terms of its position, so that the second wafer 182 still in use can be quickly replaced to the third wafer 183 later.

FIG. 4 shows a rearrangement or reclassification of the wafers 180 and 181 between the static first wafer storage device 120 and the mobile second wafer storage device 130. According to the embodiment shown in this figure, the mobile wafer storage device 130 is placed over the static storage device 120. Such placement is completed by a schematically shown mechanical arm 495, and the mechanical arm 495 grasps the mobile storage device 130 from above. If necessary, the mobile storage device 130 may be replaced into another mobile storage device containing new wafers that may be loaded with other types of chips.

According to the embodiment shown in this figure, the mobile storage device 130 has, for example, twelve storage positions 132. In contrast, the static storage device 120 has a significantly larger number of storage positions 122. In principle, the number of static storage positions 122 is not limited, and therefore the number is generally represented as "n" in FIG. 4. Possible values of "n" are, for example, 24, 32 and 40, and the number n depends on the number of different wafers or chips that may be required for one or more subsequent assembly tasks.

In order to prepare for an assembly task of providing a "correct" type of chips in the future, the wafers 180 can be classified between the static storage device 120 and the mobile storage device 130 by the wafer conveying device 140. This procedure is exemplarily shown in FIG. 4, wherein the wafers 180 are transferred downward from the sixth storage position to the second storage position at the top of the static storage device 120. In addition, in FIG. 4, the first wafer 181 is just located at the first conveying station 141 at the upper portion of the wafer conveying device 140, and is conveyed upward into the ninth storage position of the mobile storage device 130.

During such reclassification, wafers that have been mostly completely consumed and/or may be expected not to be used for an assembly task in the future are preferably stored in the mobile storage device 130. After such reclassification, the mobile storage device 130 can then be picked up by the mechanical arm 495 and replaced into another mobile storage device containing other wafers having a larger number of chips and/or types of chips to be assembled in the near future. The wafers 180 that have been picked up are either sorted out as waste or stored in a central cache device (not shown) for later use.

In principle, the assembly can be continued during the replacement of the above mobile storage device 130. As a result of the previous reclassification, if the static storage device 120 contains appropriate wafers, the assembly can be efficiently and reliably continued for a rather long period of time with the help of appropriate and rapid wafer replacement. This period of time is fully available to replacement of the above mobile storage device 130. Therefore, it is not necessary for the mechanical arm 495 to keep ready for replacement of the above storage device during the whole period. Specifically, the mechanical arm may also be used for any other purpose. For these other purposes, it is only required to leave enough time within the period of time during which the replacement of the above storage device can be performed.

Reclassification may also be expanded to a relatively long period of time without losing configuration performance, and different wafers from the static storage device are exhausted at different times. Once exhausted, the wafers can be transferred into the mobile storage device 130. In this way, the problem of "asynchronous" consumption of different wafers can be solved without additional downtime of the automatic assembly machine (not shown in FIG. 4).

For efficient reclassification, the equipping of the wafers in the two storage devices 120 and 130 should be in such a manner that there are always a sufficient number of free storage positions 122 and 132 available. If this case is met, the wafer providing apparatus 100 described herein provides a variety of strategies, which can not only supply a large number of different types of chips for the assembly without long-time shutdown of the automatic assembly machine, but also ensure sufficient supply of the wafers and efficient disposal of old wafers.

It should be noted that the term "comprise" does not exclude other elements, and "a/an" does not exclude a plurality. Moreover, elements described in corporation with different embodiments may be combined. It should also be noted that the reference numerals in the claims should not be construed as limiting the scope of the claims.

### LIST OF REFERENCE NUMERALS

- 100: Wafer providing apparatus
- 102: Wafer replacement area
- 104: Wafer provision area
- 110: Wafer receiving device
- 112: Bearing table
- 114: Clamping ring
- 120: (Static) storage device
- 122: Storage position
- 130: (Mobile) additional storage device
- 132: Additional storage position
- 140: Wafer conveying device
- 141: First conveying station
- 142: Second conveying station
- 150: Shifting device
- 160: Transfer device
- 161: First transfer mechanism
- 162: Clamp
- 163a: First linear driver / static guide rod
- 163b: First linear driver / mobile driving unit
- 164: First guide rail
- 166: Second transfer mechanism
- 167: Sliding rod
- 168a: Second linear driver / static guide rod
- 168b: Second linear driver / mobile driving unit
- 169: Second guide rail
- 170: Automatic assembly machine
- 172: Machine frame
- 174: Assembly head
- 176: Chip holding device / suction forceps
- 180: Wafer
- 180a: Frame structure
- 181: First wafer
- 182: Second wafer
- 183: Third wafer
- 190: Chip
- 192: Component carrier / printed circuit board
- 495: Mechanical arm

## Claims

1. An apparatus (100) for providing wafers (180, 181, 182) with separated chips (190) for an automatic assembly machine (170), comprising:
a receiving device (110) for receiving the provided wafers (180, 181, 182) to remove the chips (190) by an assembly head (174) of the automatic assembly machine (170);
a storage device (120) having a plurality of storage positions (122) for accommodating each wafer (180); and
a wafer conveying device (140) for conveying the wafers (181, 182, 183) between the storage device (120) and the receiving device (110), wherein
the wafer conveying device (140) has at least a first conveying station (141) and a second conveying station (142), and is configured to first transfer a first wafer (181) from the receiving device (110) to the first conveying station (141) and then transfer a second wafer (182) from the second conveying station (142) to the receiving device (110).

2. The apparatus (100) according to Claim 1, wherein the wafer conveying device is configured to
(i) transfer the wafers between each of the storage positions (122) and the first conveying station (141), and/or
(ii) transfer the wafers between each of the storage positions (122) and the second conveying station (142).

3. The apparatus (100) according to Claim 1 or 2, wherein the first conveying station (141) and the second conveying station (142) are configured
such that a first orientation of the first wafer (181) at the first conveying station (141) is parallel to a second orientation of the second wafer (182) at the second conveying station (142), and
the two conveying stations (141, 142) are staggered perpendicular to main planes of the two wafers (181, 182).

4. The apparatus (100) according to any one of Claims 1 to 3, further comprising a shifting device (150), which is coupled to the wafer conveying device (140) and configured to translate the wafer conveying device (140) along a first direction, so as to be reachable to each storage position (122) of the storage device (120) to transfer the wafers (180, 182) between the storage device (120) and the wafer conveying device (140).

5. The apparatus (100) according to Claim 4, wherein the first direction is perpendicular to a second direction in which the wafers are transferred between the wafer conveying device (140) and the receiving device (110).

6. The apparatus (100) according to Claim 5, wherein the first direction is a vertical z-direction, and the second direction is a horizontal x-direction.

7. The apparatus (100) according to any one of Claims 1 to 6, further comprising a transfer device (160), which is configured to
(i) transfer the wafers (180) between the wafer conveying device (140) and the storage device (120), and/or
(ii) transfer the wafers (180) between the wafer conveying device (140) and the receiving device (110).

8. The apparatus (100) according to Claim 7, wherein the transfer device (160) comprises:
a first transfer mechanism (161) associated with the first conveying station (141); and
a second transfer mechanism (166) associated with the second conveying station (142).

9. The apparatus according to any one of Claims 1 to 8, wherein the wafer conveying device comprises at least one third conveying station so that a third wafer may be conveyed between the storage device and the receiving device.

10. The apparatus according to any one of Claims 1 to 9, wherein the storage device is a static storage device (120), which may be coupled to a machine frame (172) of the automatic assembly machine (170) in a position-fixed manner.

11. The apparatus (100) according to any one of Claims 1 to 10, further comprising an additional storage device (130) having a plurality of additional storage positions (132) for receiving each wafer (180), wherein the wafer conveying device (140) is configured to convey the wafers (180) between the additional storage device (130) and the receiving device (110).

12. The apparatus (100) according to Claim 11, wherein the additional storage device is a mobile storage device (130), which is directly or indirectly attached to the machine frame or the storage device (120) of the apparatus in a replaceable manner.

13. The apparatus (100) according to Claim 11 or 12, wherein the wafer conveying device (140) is further configured to convey the wafers between the storage positions (122) of the storage device (120) and the additional storage positions (132) of the additional storage device (130).

14. A system for assembling chips (190) to a component carrier (192), comprising:
an automatic assembly machine (170) with an assembly head (174) for picking up the chips (190) and placing the chips (190) at a predetermined assembly position on the component carrier (192); and
an apparatus (100) according to any one of Claims 1 to 13 for providing the chips (190) of wafers (180, 181, 182) accommodated in a receiving device (110).

15. A method for providing wafers (180, 181, 182) with separated chips (190) for an automatic assembly machine (170) by an apparatus (100) according to any one of Claims 1 to 13, comprising:
transferring a first wafer (181) from a receiving device (110) to a first conveying station (141); and
transferring a second wafer (182) from a second conveying station (142) to the receiving device (110).

16. The method according to Claim 15, further comprising:
conveying the first wafer (181) into a storage device (120) by a wafer conveying device (140); and
conveying a third wafer (183) from the storage device (120) to a provision position beside the receiving device (110) by the wafer conveying device (140).

17. The method according to Claim 16, further comprising:
transferring the second wafer (182) from the receiving device (110) to a conveying station unoccupied by the third wafer (183); and
transferring the third wafer (183) from the wafer conveying device (140) to the receiving device (110).

18. The method according to any one of Claims 15 to 17, further comprising:
changing mechanical tension of an adhesive film tensioned by a frame structure (180a) of a corresponding wafer (180) and attached with separated chips, wherein
the mechanical tension is changed when the corresponding wafer (180) is located in the wafer conveying device (140).
